# EUROPEAN PATENT SPECIFICATION

(11) **EP 4 403 929 B1**
(45) Date of publication and mention of the grant of the patent: **11.02.2026**
(21) Application number: 22870007.6
(22) Date of filing: 14.09.2022
(51) Int. Cl.: G01R 19/00, G01R 31/382, G01R 31/392, G01R 31/396, H01M 10/42, H01M 10/48, H01M 50/51, H02J 7/00, H02J 7/14, H01M 50/569, G01R 19/165

(54) **VOLTAGE MEASUREMENT DEVICE AND BATTERY PACK SYSTEM**
SPANNUNGSMESSVORRICHTUNG UND BATTERIEPACKSYSTEM
DISPOSITIF DE MESURE DE TENSION ET SYSTÈME DE BLOC-BATTERIE

(30) Priority: 15.09.2021 US 202163244598 P
(43) Date of publication of application: 24.07.2024
(73) Proprietor: Nuvoton Technology Corporation Japan, Nagaokakyo City, Kyoto 617-8520 (JP)
(72) Inventor: HATANI, Naohisa, Nagaokakyo City, Kyoto 617-8520 (JP); OZEKI, Toshiaki, Nagaokakyo City, Kyoto 617-8520 (JP); MORI, Goro, Nagaokakyo City, Kyoto 617-8520 (JP)
(74) Representative: Novagraaf International SA
(86) International application number: PCT/JP2022/034446
(87) International publication number: WO 2023/042860

(56) References cited:
- WO-A1-2020/129577
- JP-A- 2011 069 639
- JP-A- 2015 136 255
- JP-A- 2016 025 794
- JP-B2- 5 753 764
- US-A1- 2012 229 094
- US-A1- 2014 350 878
- US-A1- 2017 038 434
- US-A1- 2020 028 369

## Description

### [Technical Field]

The present disclosure relates to voltage measurement devices and cell stack systems.

### [Background Art]

A cell stack of many battery cells connected in series is used as a high-capacity, high-power battery to, for example, drive motors in electric vehicles, hybrid vehicles, etc. In order to ensure safe and long-lasting use of a cell stack, the voltage of each battery cell (or each battery module) in the cell stack must be constantly monitored. To this end, consideration is being given to a device for measuring the voltage of each battery cell. For example, Patent Literature (PTL) 1 discloses a device that includes an RC filter at the voltage detection terminal, and connects the node opposite the voltage detection terminal of the capacitor to GND.

### [Citation List]

### [Patent Literature]

[PTL 1] Japanese Unexamined Patent Application Publication No. 2011-185941

### [Summary of Invention]

### [Technical Problem]

However, in the device disclosed in PTL 1, the capacitor connected to the upper battery cell of the cell stack (for example, battery module E1 in PTL 1) is subjected to a potential difference between the total voltage of the number of battery cells and GND, and thus requires high withstand voltage characteristics. An example of a voltage measuring device, which is capable of lowering withstand voltage limits for the capacitors of the low-pass RC filters is found in US 2014/350878 A1.

In view of this, the present disclosure provides a voltage measurement device and a cell stack system that can reduce the required withstand voltage characteristics of the capacitors connected to the battery cells.

### [Solution to Problem]

A voltage measurement device according to one aspect of the present disclosure individually detects, in a cell stack of n battery cells connected in series, a voltage of each of the n battery cells, n being an integer greater than or equal to two, and includes: (n+1) first resistor elements, first terminals of which are connected to a positive electrode of an upper-end battery cell among the n battery cells, a negative electrode of a lower-end battery cell among the n battery cells, and connection points between the n battery cells; (n+1) first capacitors, first terminals of which are respectively connected to second terminals of the (n+1) first resistor elements; and a voltage measurer connected to the second terminals of the (n+1) first resistor elements. Second terminals of two or more first capacitors among the (n+1) first capacitors are connected to a positive electrode of a k-th battery cell among the n battery cells, k being an integer greater than or equal to one and less than or equal to n-1.

A cell stack system according to one aspect of the present disclosure includes: the above-described voltage measurement device; and a cell stack of n battery cells connected in series, n being an integer greater than or equal to two.

### [Advantageous Effects of Invention]

According to one aspect of the present disclosure, a voltage measurement device and the like that can reduce the required withstand voltage characteristics of capacitors connected to battery cells can be realized.

### [Brief Description of Drawings]

[FIG. 1]

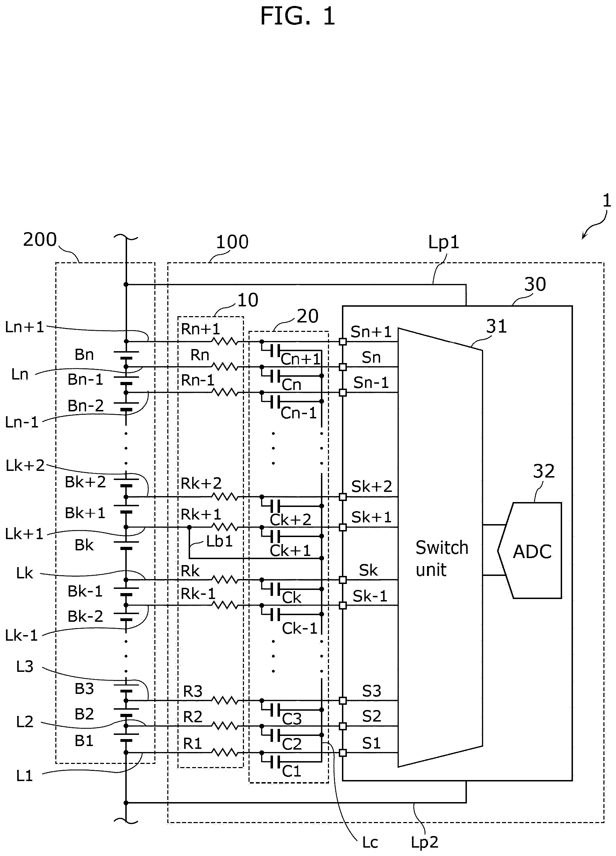

   FIG. 1 is a block diagram illustrating the configuration of a cell stack system according to Embodiment 1.
[FIG. 2]

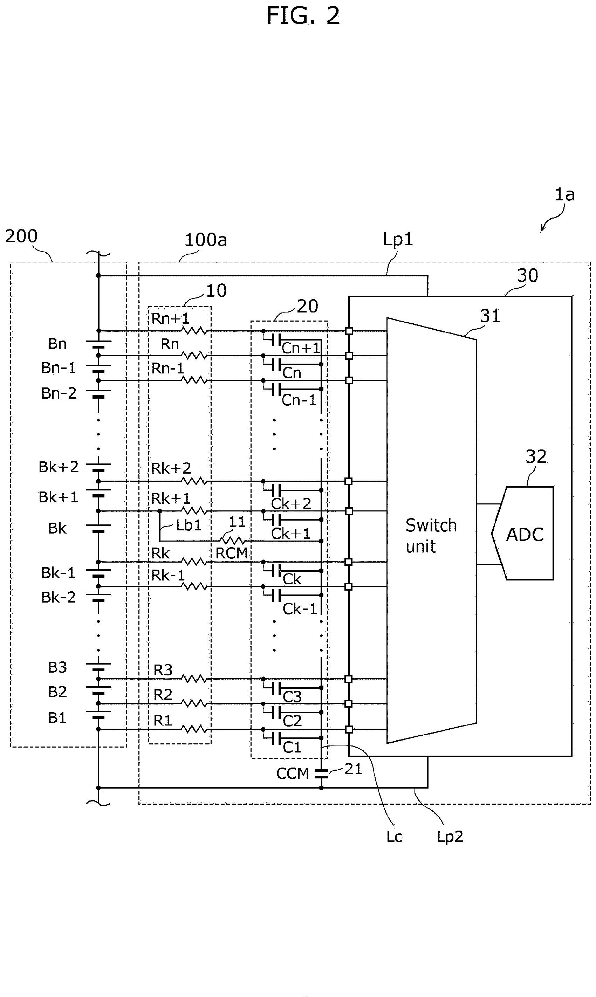

   FIG. 2 is a block diagram illustrating the configuration of a cell stack system according to a variation of Embodiment 1.
[FIG. 3]

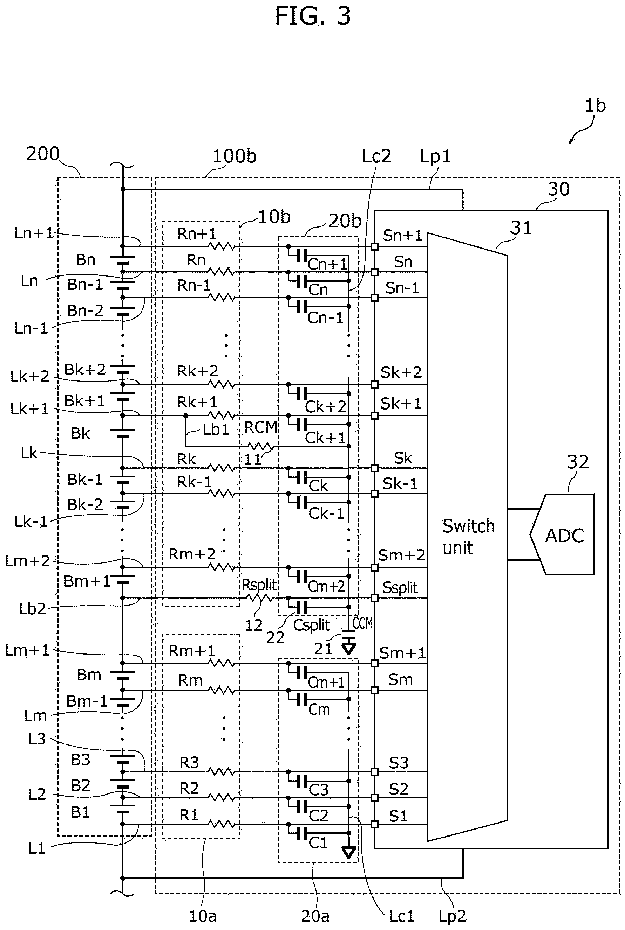

   FIG. 3 is a block diagram illustrating the configuration of a cell stack system according to Embodiment 2.
[FIG. 4]

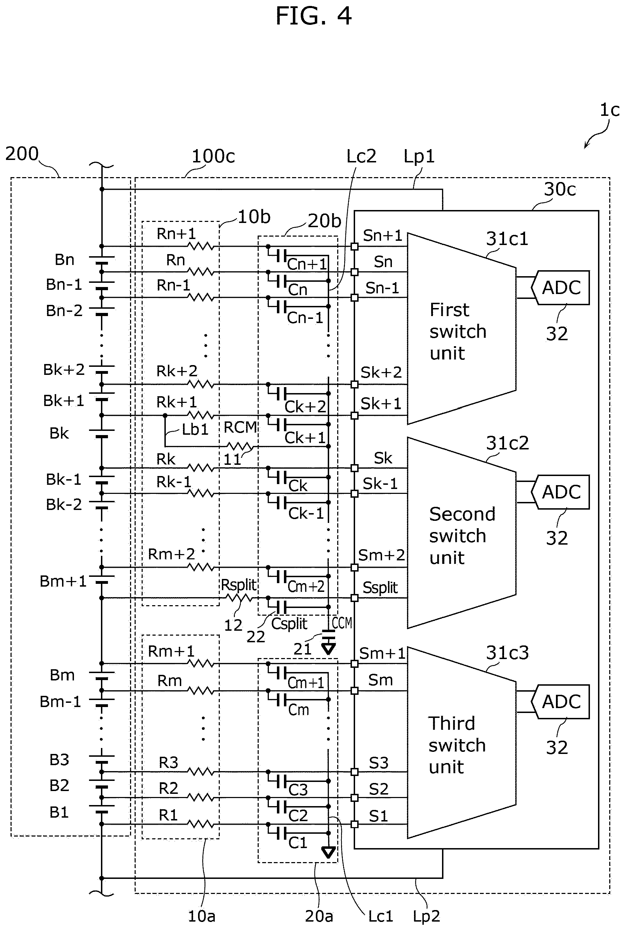

   FIG. 4 is a block diagram illustrating the configuration of a cell stack system according to Variation 1 of Embodiment 2.
[FIG. 5]

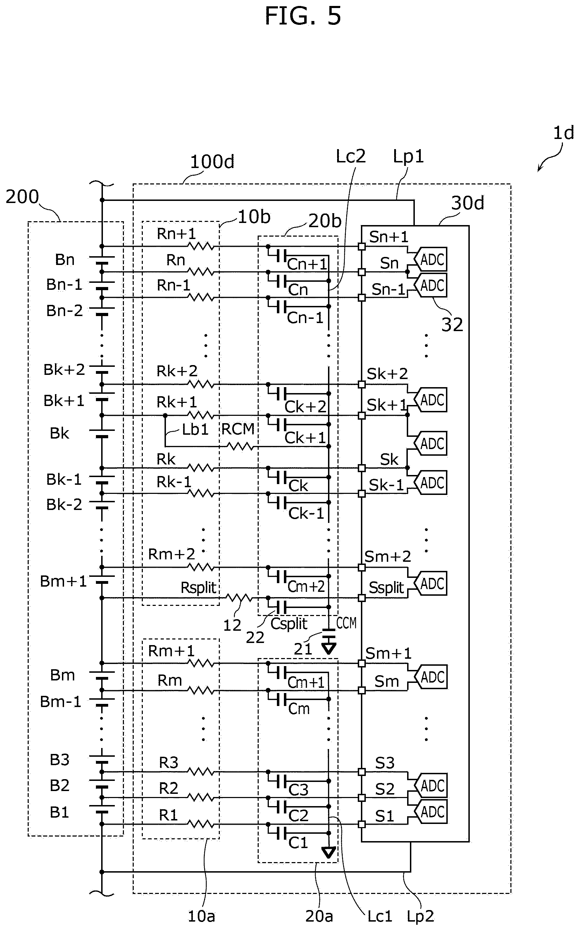

   FIG. 5 is a block diagram illustrating the configuration of a cell stack system according to Variation 2 of Embodiment 2.

### [Description of Embodiments]

Hereinafter, embodiments will be described in detail with reference to the accompanying Drawings.

Each embodiment described below illustrates a general or specific example. The numerical values, elements, the arrangement and connection of the elements, etc., in the embodiments are mere examples, and therefore are not intended to limit the present disclosure. Accordingly, among elements in the following embodiments, those not recited in any of the independent claims are described as optional elements.

Note that the figures are schematic illustrations and are not necessarily precise depictions. Accordingly, the figures are not necessarily to scale. Moreover, in the figures, the same reference signs are used for elements that are essentially the same. Accordingly, duplicate description is omitted or simplified.

In the present specification, terms indicating relationships between elements such as "match", numerical values, and numerical ranges refer not only to their strict meanings, but encompass a range of essentially equivalents, such as a range of deviations of a small percent (for example 10%).

In the present specification, ordinal numbers such as "first" and "second" are used not to imply a specific number or order of elements, unless specifically stated otherwise, but rather to avoid confusion among similar components and to distinguish them.

### Embodiment 1

### 1-1. Cell Stack System Configuration

The voltage measurement device and the cell stack system according to the present embodiment will be described with reference to FIG. 1. As illustrated in FIG. 1, cell stack system 1 includes cell stack 200 and voltage measurement device 100. In a battery management system that manages the state of a battery system including one or more cell stacks 200, cell stack system 1 measures the voltages of a plurality of battery cells B1 through Bn included in cell stack 200 in order to manage the state of the battery system. Cell stack system 1 may be an element included in the battery management system.

Cell stack 200 includes a plurality of battery cells B1 through Bn, including battery cells B1, B2, B3, Bk-2, Bk-1, Bk, Bk+1, Bk+2, Bn-2, Bn-1, and Bn, which are connected in series. n is a positive integer (for example, an integer greater than or equal to two, that is, a natural number greater than or equal to two), and k is an integer greater than or equal to one and less than or equal to n-1.

Both ends of each of the plurality of battery cells B1 and the like are connected to voltage measurer 30 via two of the plurality of voltage detection lines L1 through Ln+1.

The number of the plurality of battery cells B1 through Bn included in cell stack 200, as well as the voltage of each of the plurality of battery cells B1 through Bn, are not particularly limited. For example, each of the plurality of battery cells B1 through Bn may be of the same specification. Cell stack 200 is the measurement target of voltage measurement device 100.

Hereinafter, the plurality of battery cells B1 through Bn may also be referred to as the "plurality of battery cells B1 and the like". When referring to any single battery cell, the term "battery cell" may be used without an accompanying reference sign. Battery cell Bn is the battery cell arranged at the highest electric potential side among the plurality of battery cells B1 and the like, and is also the upper-end battery cell among the plurality of battery cells B1 and the like. Battery cell B1 is the battery cell arranged at the lowest electric potential side among the plurality of battery cells B1 and the like, and is also the lower-end battery cell among the plurality of battery cells B1 and the like.

Voltage measurement device 100 measures the voltage of cell stack 200. Voltage measurement device 100 independently detects the voltage of each of the plurality of battery cells B1 and the like included in cell stack 200. Voltage measurement device 100 is configured to be able to individually measure the voltage of each of the plurality of battery cells B1 and the like. As a result, even in cases where the overall voltage of cell stack 200 is too high for direct measurement, voltage can be measured, and the operation of each of the plurality of battery cells B1 and the like can be determined. Voltage measurement device 100 sequentially measures the voltages of the plurality of battery cells B1 and the like.

Voltage measurement device 100 includes a plurality of voltage detection lines L1 through Ln+1, resistor group 10, capacitor group 20, line Lb1, and voltage measurer 30. Resistor group 10 and capacitor group 20 form a filter circuit.

The plurality of voltage detection lines L1 through Ln+1 include voltage detection lines L1, L2, L3, Lk-1, Lk, Lk+1, Lk+2, Ln-1, Ln, and Ln+1, and are lines for measuring the voltage of each of the plurality of battery cells B1 and the like. The plurality of voltage detection lines L1 through Ln+1 connect the nodes arranged between each battery cell and on the outer sides of the battery cells at both ends (the black circles within the dashed line frame indicating cell stack 200 in FIG. 1) with input terminals S1 through Sn+1 of voltage measurer 30.

For example, voltage detection lines Ln+1 and Ln are provided for measuring the voltage of battery cell Bn. Voltage detection line Ln+1 connects the positive electrode of battery cell Bn to input terminal Sn+1, and voltage detection line Ln connects the negative electrode of battery cell Bn to input terminal Sn. For example, voltage detection lines Ln and Ln-1 are provided for measuring the voltage of battery cell Bn-1. Voltage detection line Ln connects the positive electrode of battery cell Bn-1 to input terminal Sn, and voltage detection line Ln-1 connects the negative electrode of battery cell Bn-1 to input terminal Sn-1. Voltage detection line Ln is a common line shared by both the negative electrode of battery cell Bn and the positive electrode of battery cell Bn-1. Each of voltage detection lines L2 through Ln is a common line shared by adjacent battery cells.

Note that the number of voltage detection lines L1 through Ln+1 provided is one more than the number of the plurality of battery cells B1 and the like. Hereinafter, the plurality of voltage detection lines L1 through Ln+1 may also be referred to as the "plurality of voltage detection lines L1 and the like". When referring to any single voltage detection line, the term "voltage detection line" may be used without an accompanying reference sign.

The voltage of each battery cell in the plurality of battery cells B1 and the like is input to voltage measurer 30 via the plurality of voltage detection lines L1 and the like and the filter circuit.

Resistor group 10 includes a plurality of resistor elements R1 through Rn+1, including resistor elements R1, R2, R3, Rk-1, Rk, Rk+1, Rk+2, Rn-1, Rn, and Rn+1. The plurality of resistor elements R1 through Rn+1 are respectively arranged on the plurality of voltage detection lines L1 through Ln+1. Stated differently, one resistor element is arranged on one voltage detection line. The resistor element is realized, for example, by a resistor with a desired resistance value. The plurality of resistor elements R1 through Rn+1 each include a first terminal and a second terminal. The first terminals are connected to the positive electrode of upper-end battery cell Bn, the negative electrode of lower-end battery cell B1, and the connection points (nodes) between the battery cells. The second terminals are connected to voltage measurer 30.

Hereinafter, the plurality of resistor elements R1 through Rn+1 may also be referred to as the "plurality of resistor elements R1 and the like". When referring to any single resistor element, the term "resistor element" may be used without an accompanying reference sign. The resistor element is one example of the first resistor element, and the plurality of resistor elements R1 through Rn+1 are one example of the (n+1) first resistor elements.

Capacitor group 20 includes a plurality of capacitors C1 through Cn+1, including capacitors C1, C2, C3, Ck-1, Ck, Ck+1, Ck+2, Cn-1, Cn, and Cn+1. For example, each of the plurality of capacitors C1 through Cn+1 has the same withstand voltage characteristics. The first terminals (first electrodes) of the plurality of capacitors C1 through Cn+1 are respectively connected to the second terminals of the plurality of resistor elements R1 through Rn+1. Stated differently, the first terminal of one capacitor is connected to the second terminal of one resistor element. Each second terminal (second electrode) of capacitors C1 through Cn+1 is connected together via line Lc and has the same electric potential.

Note that it is sufficient if line Lc connects each second terminal of two or more of the plurality of capacitors C1 through Cn+1, including capacitor Cn+1, to line Lb1. Line Lc is not connected to a direct current (DC) stable node such as ground (GND) or the power supply of voltage measurer 30.

Hereinafter, the plurality of capacitors C1 through Cn+1 may also be referred to as the "plurality of capacitors C1 and the like". When referring to any single capacitor, the term "capacitor" may be used without an accompanying reference sign. The capacitor is one example of the first capacitor, and the plurality of capacitors C1 through Cn+1 are one example of the (n+1) first capacitors.

The filter circuit is a circuit for removing ripples (noise) included in the DC voltage. As resistor group 10 and capacitor group 20 show, the filter circuit includes n+1 RC filters respectively connected to the plurality of voltage detection lines L1 through Ln+1. The filter circuits can remove the ripples included in the DC voltage inputted to voltage measurer 30 from each of the plurality of voltage detection lines L1 through Ln+1.

Line Lb1 is a line for connecting the positive electrode of battery cell Bk to line Lc. Line Lb1 connects the node between battery cells Bk and Bk-1 to line Lc. Stated differently, voltage measurement device 100 makes each second terminal of the plurality of capacitors C1 and the like the intermediate electric potential in cell stack 200 (in the example of FIG. 1, the total voltage of battery cells B1 through Bk) instead of GND. Each second terminal of the plurality of capacitors C1 and the like can be said to be grounded to an intermediate electric potential. The intermediate electric potential is a voltage greater than or equal to the voltage of battery cell B1 and less than or equal to the total electric potential of battery cells B1 through Bn-1. Note that line Lb1 is not connected to voltage measurer 30.

Thus, in voltage measurement device 100, each second terminal of the plurality of capacitors C1 and the like and the positive electrode of the k-th battery cell Bk among the plurality of battery cells B1 and the like are connected by line Lb1.

In this case, the potential difference that occurs in capacitor Cn+1 is the difference between a first total voltage (voltage at the first terminal of capacitor Cn+1), which is the sum total of the voltages of battery cells B1 through Bn, and a second total voltage (voltage at the second terminal of capacitor Cn+1), which is the sum total of the voltages of battery cells B1 through Bk. Stated differently, the potential difference that occurs in capacitor Cn+1 is a third total voltage, which is the sum total of the voltages of battery cells Bk+1 through Bn. In this case, the potential difference that occurs in capacitor C1 is the difference between the voltage at the negative electrode side of battery cell B1 (voltage at the first terminal of capacitor C1) and the total voltage of battery cells B1 through Bk (voltage at the second terminal of capacitor C1). Stated differently, the potential difference that occurs in capacitor C1 is a second total voltage, which is the sum total of the voltages of battery cells B1 through Bk. The potential difference that occurs in capacitor Ck+1 is zero.

From the perspective of reducing the required withstand voltage characteristics of the capacitors connected to the battery cells, battery cell Bk may be arranged in the middle of cell stack 200. Here, "middle" refers to the n/2-th battery cell when n is an even number, and to the (n-1)/2-th battery cell when n is an odd number. For example, when n=10 or n=11, k may be 5. Note that battery cell Bk, to the positive electrode of which line Lb1 is connected, is not limited to being the middle (k=n/2) battery cell in cell stack 200, and may be any battery cell represented by an integer k that is greater than or equal to two and less than or equal to n. Stated differently, it is sufficient if line Lb1 is connected so as to connect the node between two battery cells connected in series and line Lc.

In voltage measurement device 100, it is sufficient if the second terminals of two or more capacitors among the plurality of capacitors C1 and the like and the positive electrode of the k-th battery cell Bk among the plurality of battery cells B1 and the like are connected by line Lb1.

Note that the value of k is not limited to the above examples, and may be determined so that the maximum potential difference that occurs in any of capacitors C1 through Ck connected to battery cells B1 through Bk (for example, the potential difference that occurs in capacitor C1) matches or falls within a predetermined range of the maximum potential difference that occurs in any of capacitors Ck+1 through Cn connected to battery cells Bk+1 through Bn (for example, the potential difference that occurs in capacitor Cn). Here, the predetermined range is, for example, but not limited to, the voltage of a few battery cells.

Voltage measurer 30 is a device that detects the voltage of each of the plurality of battery cells B1 and the like. Voltage measurer 30 is configured to include, for example, an integrated circuit (IC).

Voltage measurer 30 includes switch unit 31 and an analog to digital converter (ADC) 32. Voltage measurer 30 includes a plurality of input terminals S1 through Sn+1, including input terminals S1, S2, S3, Sk-1, Sk, Sk+1, Sk+2, Sn-1, Sn, and Sn+1, to which a plurality of voltage detection lines L1 and the like are connected together. Although not illustrated in the figures, voltage measurer 30 may include a controller or the like for storing each cell voltage converted to digital data.

Switch unit 31 is realized, for example, by a multiplexer that includes a plurality of switches. The switches are provided for each of the plurality of input terminals S1 through Sn+1. The switches may be, but are not limited to, relays (for example, PhotoMOS relays).

Periodically, switch unit 31 sequentially selects and outputs the voltages of the plurality of battery cells B1 and the like in cell stack 200 to ADC 32. In switch unit 31, the turning on and off of the plurality of switches is controlled so as to measure individual battery cell voltage.

ADC 32 converts the voltage (analog value) output from switch unit 31 into a digital value and outputs it to the controller or the like.

Voltage measurer 30 receives and operates on an external supply of power. For example, voltage measurer 30 may receive a supply of power by being connected to the positive electrode of battery cell Bn via line Lp1. Voltage measurer 30 is connected to a DC-stable node via line Lp2, and in the example of FIG. 1, is connected to the negative electrode of the lower-end battery cell B1. Note that the DC-stable node may be, for example, GND (for example, the GND of the substrate on which voltage measurer 30 is mounted).

### 1-2. Advantages Effects, etc.

As described above, voltage measurement device 100 according to the present embodiment individually detects, in cell stack 200 of a plurality of battery cells B1 and the like-specifically, n battery cells B1 and the like (n is an integer greater than or equal to two)-connected in series, a voltage of each of the n battery cells B1 and the like. Voltage measurement device 100 includes: a plurality of resistor elements R1 and the like (one example of the (n+1) first resistor elements), first terminals of which are connected to a positive electrode of the upper-end battery cell Bn among the plurality of battery cells B1 and the like, a negative electrode of the lower-end battery cell B1 among the plurality of battery cells B1 and the like, and connection points between the plurality of battery cells B1 and the like; a plurality of capacitors C1 and the like (one example of the (n+1) first capacitors), first terminals of which are respectively connected to second terminals of the plurality of resistor elements R1 and the like; and voltage measurer 30 connected to the second terminals of the plurality of resistor elements R1 and the like. Second terminals of two or more capacitors among the plurality of capacitors C1 and the like are connected to a positive electrode of the k-th battery cell Bk (k is an integer greater than or equal to one and less than or equal to n-1) among the plurality of battery cells B1 and the like.

With this, the second terminal of capacitor Cn+1, which is connected to the upper-end battery cell Bn, can be set to, for example, the total voltage of battery cells B1 through Bk. Stated differently, the potential difference that occurs in capacitor Cn+1 can be reduced compared to when the second terminal of capacitor Cn+1 is connected to GND or the like. Thus, voltage measurement device 100 can reduce the required withstand voltage characteristics of the capacitors connected to the battery cells. This contributes to the reduction of component costs in voltage measurement device 100.

The second terminals of the (n+1) plurality of capacitors C1 and the like are connected to the positive electrode of the k-th battery cell Bk.

With this, voltage measurement device 100 can reduce the required withstand voltage characteristics of the capacitors connected to the battery cells with a simple configuration that includes a line (for example, line Lc) for making each second terminal of the plurality of capacitors C1 and the like the same electric potential.

The k-th battery cell Bk is arranged at the n/2-th position among the plurality of battery cells B1 and the like.

As a result, the potential difference that occurs in capacitor Cn+1 can be halved compared to when the second terminal of capacitor Cn+1 is connected to GND or the like. Thus, voltage measurement device 100 can further reduce the required withstand voltage characteristics of the capacitors connected to the battery cells.

As described above, cell stack system 1 according to the present embodiment includes: the above-described voltage measurement device 100; and cell stack 200 of a plurality of battery cells B1 and the like-specifically, n battery cells B1 and the like (n is an integer greater than or equal to two)-connected in series.

This achieves the same advantages effects as voltage measurement device 100 described above.

### Variation of Embodiment 1

Hereinafter, the voltage measurement device and the cell stack system according to the present variation will be described with reference to FIG. 2. FIG. 2 is a block diagram illustrating the configuration of cell stack system 1a according to the present variation. In FIG. 2, illustration of reference signs for the voltage detection lines and input terminals is omitted to avoid complication. Hereinafter, description will focus on the differences from Embodiment 1, and description of content that is the same or similar to Embodiment 1 will be omitted or simplified. Voltage measurement device 100a according to the present variation differs from voltage measurement device 100 according to Embodiment 1 in that it includes resistor element 11 and capacitor 21 (that is, an RC filter).

Resistor element 11 (labeled "RCM" in FIG. 2) is arranged on line Lb1. Resistor element 11 is arranged between the first terminal of resistor element Rk+1 and line Lc. Resistor element 11 is realized, for example, by a resistor with a desired resistance value. Resistor element 11 is one example of the second resistor element.

Capacitor 21 (labeled "CCM" in FIG. 2) is arranged on line Lc. The first terminal (first electrode) of capacitor 21 is connected to each second terminal of the plurality of capacitors C1 and the like via line Lc. Stated differently, the first terminal of capacitor 21 is supplied with the intermediate electric potential in cell stack 200 (in the example of FIG. 2, the total voltage of battery cells B1 through Bk). The second terminal (second electrode) of capacitor 21 is connected to the negative electrode (line Lp2) of battery cell B1. Note that it is sufficient if the second terminal of capacitor 21 is connected to a DC-stable node. Capacitor 21 is one example of the second capacitor.

Resistor element 11 and capacitor 21 arranged in this way function as an RC filter. Note that the connection position of capacitor 21 is not limited to the position illustrated in FIG. 2, and may be connected to a terminal of any battery cell.

In voltage measurement device 100a, it is sufficient if the second terminals of two or more capacitors among the plurality of capacitors C1 and the like and the positive electrode of the k-th battery cell Bk among the plurality of battery cells B1 and the like are connected by line Lb1. Stated differently, voltage measurement device 100a may include: resistor element 11 connected between the second terminals of two or more of the plurality of capacitors C1 and the like and the positive electrode of the k-th battery cell Bk; and capacitor 21 connected to the second terminals of the two or more of the plurality of capacitors C1 or the like.

As described above, voltage measurement device 100a according to the present embodiment includes: resistor element 11 (one example of the second resistor element) connected between the second terminals of two or more first capacitors and the positive electrode of the k-th battery cell Bk; and capacitor 21 (one example of the second capacitor) connected to the second terminals of the two or more first capacitors.

With this, since resistor element 11 and capacitor 21 function as an RC filter, voltage measurement device 100a can remove the ripples included in the DC voltage that is input to line Lc via line Lb1. Stated differently, voltage measurement device 100a can inhibit fluctuations in the voltage at the second terminals of the plurality of capacitors C1 and the like that are caused by noise included in the DC voltage. Moreover, since the intermediate electric potential of cell stack 200 is supplied to the first terminal of capacitor 21, the potential difference that occurs in capacitor Cn+1 is the same as in Embodiment 1. Thus, voltage measurement device 100a can maintain the effect of reducing the required withstand voltage characteristics of the capacitors connected to the battery cells while eliminating the influence of noise.

### Embodiment 2

### 2-1. Cell Stack System Configuration

The voltage measurement device and the cell stack system according to the present embodiment will be described with reference to FIG. 3. FIG. 3 is a block diagram illustrating the configuration of cell stack system 1b according to the present embodiment. Hereinafter, description will focus on the differences from Embodiment 1, and description of content that is the same or similar to Embodiment 1 will be omitted or simplified. Voltage measurement device 100b according to the present embodiment differs from voltage measurement device 100 according to Embodiment 2 in that the filter circuit is realized by two circuits, namely the first filter circuit and the second filter circuit.

The first filter circuit is a circuit for measuring the voltage of each of battery cells B1 through Bm (where m is an integer greater than or equal to one and less than k), and includes first resistor group 10a and first capacitor group 20a. First filter circuit includes m+1 RC filters. The second terminals of capacitors C1 through Cm+1 are connected via line Lc1. Stated differently, each second terminal of capacitors C1 through Cm+1 connected to battery cells up to and including the m-th battery cell among the plurality of battery cells B1 and the like is connected together. This makes the second terminals of capacitors C1 through Cm+1 the same electric potential. In the present embodiment, the second terminals of capacitors C1 through Cm+1 are 0 V since line Lc1 is connected to GND (for example, the GND of the substrate on which voltage measurer 30 is mounted).

In the present embodiment, n is a positive integer (for example, an integer greater than or equal to three), and k is an integer greater than or equal to two and less than or equal to n-1.

The second filter circuit is a circuit for measuring the voltage of each of battery cells Bm+1 through Bn, and includes second resistor group 10b and second capacitor group 20b. Second filter circuit includes n+1-m RC filters. The second terminals of capacitors Cm+2 through Cn+1 and 22 are connected via line Lc2. Stated differently, each second terminal of capacitors Cm+2 through Cn+1 and 22 connected to, among the plurality of battery cells B1 and the like, the battery cells ranging from the m+1-th battery cell to the n-th battery cell, which include the k-th battery cell Bk, is connected together. The second terminals of the plurality of capacitors C1 and the like can be said to be divided into two groups, each with two or more second terminals connected together. In the example in FIG. 3, one group is capacitors C1 through Cm+1 and the other group is capacitors Cm+2 through Cn+1 and 22.

This makes the second terminals of capacitors Cm+2 through Cn+1 and 22 the same electric potential. In the present embodiment, the second terminals of capacitors Cm+2 through Cn+1 and 22 are the total voltage of battery cells Bm+1 through Bk since line Lc2 is connected to GND (for example, the GND of the substrate on which voltage measurer 30 is mounted). In this case, the potential difference that occurs in capacitor Ck+1 is zero. Capacitors Cm+2 through Cn+1 are one example of the two or more first capacitors.

Lines Lc1 and Lc2 may be connected to a common DC-stable node (for example, a common GND), and, alternatively, may be connected to different DC-stable nodes (for example, different GNDs).

Line Lb2 is provided to connect the node between battery cells Bm and Bm+1 and input terminal Ssplit of voltage measurer 30. Stated differently, there are two lines (voltage detection line Lm+1 and line Lb2) that connect the node between battery cells Bm and Bm+1 and voltage measurer 30.

Voltage measurement device 100b includes resistor element 12 (Rsplit in FIG. 3) and capacitor 22 (Csplit in FIG. 3), which are arranged on line Lb2 and form an RC filter.

The first terminal of resistor element 12 is connected to the positive electrode of the m-th battery cell Bm, and the second terminal of resistor element 12 is connected to voltage measurer 30. Resistor element 12 is realized, for example, by a resistor with a desired resistance value. Resistor element 12 is one example of the third resistor element.

The first terminal (first electrode) of capacitor 22 is connected to the second terminal of resistor element 12, and the second terminal (second electrode) of capacitor 22 is connected to the first terminal (first electrode) of capacitor 21. The second terminal of capacitor 22 is connected to the positive electrode of the k-th battery cell. Capacitor 22 is one example of the third capacitor.

Thus, in the present embodiment, n+2 RC filters are provided.

In this case, the potential difference that occurs in capacitor Cn+1 is the difference between a fourth total voltage (voltage at the first terminal of capacitor Cn+1), which is the sum total of the voltages of battery cells Bm+1 through Bn, and a fifth total voltage (voltage at the second terminal of capacitor Cn+1), which is the sum total of the voltages of battery cells Bm+1 through Bk. Stated differently, the potential difference that occurs in capacitor Cn+1 is a sixth total voltage, which is the sum total of the voltages of battery cells Bk+1 through Bn. In this case, the potential difference that occurs in capacitor Cm+1 is the difference between GND and the total voltage of battery cells B1 through Bm (voltage at the second terminal of capacitor Cm+1). Stated differently, the potential difference that occurs in capacitor Cm+1 is a seventh total voltage, which is the sum total of the voltages of battery cells B1 through Bm. In this case, the potential difference that occurs in capacitor 22 is the difference between the negative electrode of battery cell Bm+1 and the total voltage of battery cells Bm+1 through Bk (voltage at the second terminal of capacitor 22). Stated differently, the potential difference that occurs in capacitor 22 is an eighth total voltage, which is the sum total of the voltages of battery cells Bm+1 through Bk.

From the perspective of reducing the required withstand voltage characteristics of the capacitors connected to the battery cells, battery cell Bm may be the n/3-th battery cell from the lower electric potential side among the plurality of battery cells B1 and the like, and battery cell Bk may be the 2n/3-th battery cell from the lower electric potential side among the plurality of battery cells B1 and the like. Here, "n/3-th battery cell" refers to the n/3-th battery cell when n is a multiple of three, and to either the (n-1)/3-th or the (n+1)/3-th battery cell when n is not a multiple of three. Here, "2n/3-th battery cell" refers to the 2n/3-th battery cell when n is a multiple of three, and to either the 2(n-1)/3-th or the 2(n+1)/3-th battery cell when n is not a multiple of three. For example, when n is in the range of 11 to 13, m may be 4, and k may be 8. The value of (n-1) or (n+1) is selected such that when n is substituted, the resulting value is a multiple of three.

For example, the number of battery cells B1 through Bm, the number of battery cells Bm+1 through Bk, and the number of battery cells Bk+1 through Bn may be equal or have a difference of one or less.

Note that the values of m and k are not limited to the above examples, and may be determined so that the maximum potential difference that occurs in any of capacitors C1 through Cm+1 connected to battery cells B1 through Bm (for example, the potential difference that occurs in capacitor C1), the maximum potential difference that occurs in any of capacitors Cm+2 through Ck+1 and capacitor 22 connected to battery cells Bm+1 through Bk (for example, the potential difference that occurs in capacitor C22), and the maximum potential difference that occurs in any of capacitors Ck+1 through Cn+1 connected to battery cells Bk+1 through Bn (for example, the potential difference that occurs in capacitor Cn+1) match or fall within a predetermined range. Here, the predetermined range is, for example, but not limited to, the voltage of a few battery cells.

Note that line Lb1 may be provided in the first filter circuit so as to connect any of voltage detection lines L2 through Lm with line Lc1, and resistor element 11 and capacitor 21 may be provided to form an RC filter. In such cases, the second filter circuit need not be provided with line Lc1.

Note that each of the second terminals of capacitors C1 through Cm+1 connected to battery cells B1 through Bm does not need to be connected together; it is sufficient if each second terminal of two or more of capacitors C1 through Cm+1 is connected together. For example, the second terminals of capacitors C1 through Cm+1 connected to battery cells B1 through Bm can be divided into s groups (where s is an integer greater than or equal to two), each with two or more second terminals connected together. For example, each of the s groups can be connected to a DC-stable node such as GND. A line (for example, corresponding to line Lb1 illustrated in FIG. 3) may be provided that connects any of two or more battery cells connected via capacitors and resistors included in at least one of the s groups, to the second terminals of the capacitors in that group.

### 2-2. Measurement Method

Next, the method of measuring voltage in voltage measurement device 100b configured as described above will be described. Hereinafter, a measurement method for measuring the voltage of the (m+1)-th battery cell Bm+1 will be described.

When measuring the voltage of the (m+1)-th battery cell Bm+1, voltage measurement device 100b measures the voltage between the second terminal of the m+2-th resistor element Rm+2 and the second terminal of resistor element 12. Stated differently, when measuring the voltage of the (m+1)-th battery cell Bm+1, voltage measurement device 100b does not use m+1-th resistor element Rm+1. Voltage measurement device 100b measures the voltage of a battery cell using the second terminal of a resistor element that is connected to a common DC-stable node via capacitor 21.

When measuring the voltage of the m+1-th battery cell Bm+1, voltage measurement device 100b turns off the m+1-th first switch and turns on the m+1-th second switch and the m+2-th switch. The m+1-th first switch is the switch to which resistor element Rm+1 is connected via input terminal Sm+1, and the m+1-th second switch is the switch to which resistor element 12 is connected via input terminal Ssplit. The m+2-th switch is the switch to which resistor element Rm+2 is connected via input terminal Sm+2.

### 2-3. Advantageous Effects, etc.

As described above, voltage measurement device 100b according to the present embodiment includes: resistor element 12 (one example of the third resistor element), the first terminal of which is connected to the positive electrode of the m-th battery cell Bm (m is an integer greater than or equal to 1 and less than k) among the plurality of battery cells B1 and the like; and capacitor 22 (one example of the third capacitor) the first terminal of which is connected to the second terminal of resistor element 12. The second terminal of resistor element 12 is connected to voltage measurer 30. The second terminal of capacitor 22 is connected to the positive electrode of the k-th battery cell Bk. Each second terminal of at least two capacitors included in capacitors C1 through Cm+1 connected to, among the plurality of battery cells B1 and the like, battery cells B1 through Bm up to and including the m-th battery cell is connected together. The two or more capacitors among the plurality of capacitors C1 and the like (one example of the (n+1) first capacitors) include capacitors Cm+2 through Cn+1 connected to, among the plurality of battery cells B1 and the like, battery cells ranging from the (m+1)-th battery cell to the n-th battery cell and including the k-th battery cell Bk.

With this, the maximum value of the potential difference that occurs in the capacitor will be one of the sixth total voltage, the seventh total voltage, or the eighth total voltage described above. Depending on the values assumed by k and m, each of the sixth total voltage, the seventh total voltage, and the eighth total voltage can be made less than half of the potential difference that occurs in the capacitor connected to upper-end battery cell Bn when the plurality of capacitors C1 and the like are each connected to GND. Thus, voltage measurement device 100b can further reduce the required withstand voltage characteristics of the capacitors connected to the battery cells. This contributes to the further reduction of the component costs in voltage measurement device 100b.

When measuring the voltage of the m+1-th battery cell Bm+1, voltage measurement device 100b measures the voltage between the second terminal of the m+2-th resistor element Rm+2 (one example of the first resistor element) among the plurality of resistor elements R1 and the like and the second terminal of resistor element 12.

With this, voltage can be measured using the second terminal of the resistor element to which a capacitor with the same electric potential as the second terminal is connected, allowing for more accurate measurement of the voltage of battery cell Bm+1.

Each second terminal of capacitors C1 through Cm+1 connected to battery cells B1 through Bm is connected together, the m-th battery cell Bm is arranged at the n/3-th position among the plurality of battery cells B1 and the like, and the k-th battery cell Bk is arranged at the 2n/3-th position among the plurality of battery cells B1 and the like.

With this, the maximum value of the potential difference that occurs in the capacitors can be made 1/3 of the potential difference that occurs in the capacitor connected to upper-end battery cell Bn when the plurality of capacitors C1 and the like are each connected to GND. Stated differently, the withstand voltage of the capacitor can be reduced to approximately 1/3. Thus, voltage measurement device 100b can further reduce the required withstand voltage characteristics of the capacitors connected to the battery cells. This contributes to the further reduction of component costs in voltage measurement device 100b.

Second terminals of capacitors C1 through Cm connected to battery cells B1 through Bm are divided into s groups (s is an integer greater than or equal to two), each with two or more second terminals connected together. The s groups include a group in which each second terminal of two or more capacitors among capacitors C1 through Cm+1 connected to battery cells B1 through Bm is connected together.

With this, the required withstand voltage characteristics of the capacitors connected to the battery cells can be further reduced.

### Variation 1 of Embodiment 2

Hereinafter, the voltage measurement device and the cell stack system according to the present variation will be described with reference to FIG. 4. FIG. 4 is a block diagram illustrating the configuration of cell stack system 1c according to the present variation. Hereinafter, description will focus on the differences from Embodiment 2, and description of content that is the same or similar to Embodiment 2 will be omitted or simplified. Voltage measurement device 100c according to the present variation includes voltage measurer 30c whose configuration differs from voltage measurer 30 of voltage measurement device 100b according to Embodiment 2.

Voltage measurer 30c includes first switch unit 31c1, second switch unit 31c2, third switch unit 31c3, and a plurality of ADCs 32.

Each of first switch unit 31c1, second switch unit 31c2, and third switch unit 31c3 is realized, for example, by a multiplexer that includes a plurality of switches. First switch unit 31c1 is a switch unit for measuring the voltage of battery cells Bk+1 through Bn, second switch unit 31c2 is a switch unit for measuring the voltage of battery cells Bm+1 through Bk-1, and third switch unit 31c3 is a switch unit for measuring the voltage of battery cells B1 through Bm. ADC 32 is connected to each of first switch unit 31c1, second switch unit 31c2, and third switch unit 31c3.

Note that the number of switch units and the number of ADCs are not limited to the example illustrated in FIG. 4, and are not particularly limited as long as there are two or more of each. Additionally, which battery cell is measured by which combination of switch unit and ADC can be arbitrarily set.

In this way, in the present variation, two or more multiplexers and two or more ADCs are used to measure the voltages of the plurality of battery cells B1 and the like.

### Variation 2 of Embodiment 2

Hereinafter, the voltage measurement device and the cell stack system according to the present variation will be described with reference to FIG. 5. FIG. 5 is a block diagram illustrating the configuration of cell stack system 1d according to the present variation. Hereinafter, description will focus on the differences from Embodiment 2, and description of content that is the same or similar to Embodiment 2 will be omitted or simplified. Voltage measurement device 100d according to the present variation includes voltage measurer 30d whose configuration differs from voltage measurer 30 of voltage measurement device 100b according to Embodiment 2.

As illustrated in FIG. 5, voltage measurer 30d includes a plurality of ADCs 32. For example, battery cells and ADCs 32 are provided in one-to-one correspondence. Stated differently, n (the same number as battery cells) ADCs 32 are provided.

When measuring the voltage of the (m+1)-th battery cell Bm+1, voltage measurement device 100d measures the voltage between the second terminal of the m+2-th resistor element Rm+2 and the second terminal of resistor element 12. One ADC 32 is provided for input terminal Sm+2 and Ssplit. When measuring the voltage of the m-th battery cell Bm, voltage measurement device 100d measures the voltage between the second terminal of the m+1-th resistor element Rm+1 and the second terminal of the m-th resistor element Rm. One ADC 32 is provided for input terminal Sm+1 and Sm.

Voltage measurer 30d according to the present variation does not include a switch unit (for example, a multiplexer).

This simplifies the configuration of voltage measurer 30d since voltage measurer 30d can carry out its functions without including a switch unit. This can contribute to cost reduction in voltage measurement device 100d.

### Other Embodiments

Although the voltage measurement device and the like according to one or more aspects have been described based on embodiments and the like, the present disclosure is not limited to these embodiments and the like. The invention is defined by the appended claims.

For example, the description in each of the above embodiments pertains to the use of one cell stack system, but at least one of the positive electrode of the upper-end battery cell or the negative electrode of the lower-end battery cell may be connected to a battery cell in another cell stack system. Moreover, the negative electrode of the lower-end battery cell may be connected to GND.

Each element of the voltage measurement device described in the above embodiments and the like may be realized as software and may be typically realized as a LSI circuit, which is an integrated circuit. Each element may be realized as an individual chip, and alternatively, one or more elements may be integrated in a single chip. Although this kind of integration is referred to as "LSI" here, depending on the degree of integration, it may also be referred to as IC, system LSI, super LSI, or ultra LSI. The method of integration is not limited to LSI; each element may be realized as a dedicated circuit (a general circuit that executes a dedicated program) or a general processor. After the LSI circuit is manufactured, a field programmable gate array (FPGA) or a reconfigurable processor capable of reconfiguring the connections and settings of the circuit cells in the LSI circuit may be used. Furthermore, when advancement in semiconductor technology or derivatives of other technologies brings forth a circuit integration technology which replaces LSI, it will be appreciated that such a circuit integration technology may be used to integrate the elements.

### [Industrial Applicability]

For example, the present disclosure is applicable as a voltage measurement device and a cell stack system for vehicular applications.

### [Reference Signs List]

1, 1a, 1b, 1c, 1d cell stack system
10 resistor group
10a first resistor group
10b second resistor group
11 resistor element (second resistor element)
12 resistor element (third resistor element)
20 capacitor group
20a first capacitor group
20b second capacitor group
21 capacitor (second capacitor)
22 capacitor (third capacitor)
30, 30c, 30dvoltage measurer
31 switch unit
31c1 first switch unit
31c2 second switch unit
31c3 third switch unit
32 ADC
100, 100a, 100b, 100c, 100d voltage measurement device
200 cell stack
B1, B2, B3, Bm-1, Bm, Bm+1, Bk-2, Bk-1, Bk, Bk+1, Bk+2, Bn-2, Bn-1, Bn battery cell
C1, C2, C3, Cm, Cm+1, Cm+2, Ck-1, Ck, Ck+1, Ck+2, Cn-1, Cn, Cn+1 capacitor (first capacitor)
L1, L2, L3, Lm, Lm+1, Lm+2, Lk-1, Lk, Lk+1, Lk+2, Ln-1, Ln, Ln+1 voltage detection line
Lb1, Lb2, Lc, Lc1, Lc2, Lp1, Lp2line
R1, R2, R3, Rm, Rm+1, Rm+2, Rk-1, Rk, Rk+1, Rk+2, Rn-1, Rn, Rn+1 resistor element (first resistor element)
S1, S2, S3, Sm, Sm+1, Sm+2, Sk-1, Sk, Sk+1, Sk+2, Sn-1, Sn, Sn+1, Ssplit input terminal

## Claims

1. A voltage measurement device (100) that individually detects, in a cell stack (200) of n battery cells (B₁...Bₙ) connected in series, a voltage of each of the n battery cells, n being an integer greater than or equal to two, the voltage measurement device (100) comprising:
(n+1) first resistor elements (R₁...Rₙ₊₁), first terminals of which are connected to a positive electrode of an upper-end battery cell among the n battery cells, a negative electrode of a lower-end battery cell among the n battery cells, and connection points between the n battery cells;
(n+1) first capacitors (C₁...Cₙ₊₁), first terminals of which are respectively connected to second terminals of the (n+1) first resistor elements; and
a voltage measurer (30) connected to the second terminals of the (n+1) first resistor elements,
**characterized in that**
second terminals of two or more first capacitors among the (n+1) first capacitors are connected to a positive electrode of a k-th battery cell among the n battery cells, k being an integer greater than or equal to one and less than or equal to n-1.

2. The voltage measurement device according to claim 1, further comprising:
a second resistor element connected between the second terminals of the two or more first capacitors and the positive electrode of the k-th battery cell; and
a second capacitor connected to the second terminals of the two or more first capacitors.

3. The voltage measurement device according to claim 1 or 2, wherein
second terminals of the (n+1) first capacitors are connected to the positive electrode of the k-th battery cell.

4. The voltage measurement device according to claim 1 or 2, further comprising:
a third resistor element, a first terminal of which is connected to a positive electrode of an m-th battery cell among the n battery cells, m being an integer greater than or equal to one and less than k; and
a third capacitor, a first terminal of which is connected to a second terminal of the third resistor element, wherein
the second terminal of the third resistor element is connected to the voltage measurer,
a second terminal of the third capacitor is connected to the positive electrode of the k-th battery cell,
among the (n+1) first capacitors, each second terminal of at least two first capacitors included in first capacitors connected to, among the n battery cells, battery cells up to and including the m-th battery cell is connected together, and
the two or more first capacitors among the (n+1) first capacitors include first capacitors connected to, among the n battery cells, battery cells ranging from a (m+1)-th battery cell to an n-th battery cell and including the k-th battery cell.

5. The voltage measurement device according to claim 4, wherein
when measuring a voltage of the (m+1)-th battery cell, the voltage measurement device measures a voltage between the second terminal of a (m+2)-th first resistor element among the (n+1) first resistor elements and the second terminal of the third resistor element.

6. The voltage measurement device according to any one of claims 1 to 5, wherein
the k-th battery cell is arranged at a n/2-th position among the n battery cells.

7. The voltage measurement device according to claim 4 or 5, wherein
among the (n+1) first capacitors, each second terminal of first capacitors connected to, among the n battery cells, battery cells up to and including the m-th battery cell is connected together,
the m-th battery cell is arranged at a n/3-th position among the n battery cells, and
the k-th battery cell is arranged at a 2n/3-th position among the n battery cells.

8. The voltage measurement device according to claim 4 or 5, wherein
among the (n+1) first capacitors, second terminals of first capacitors connected to, among the n battery cells, battery cells up to and including the m-th battery cell are divided into s groups, each with two or more second terminals connected together, s being an integer greater than or equal to two, and
the s groups include a group in which each second terminal of the at least two first capacitors included in the first capacitors connected to the battery cells up to and including the m-th battery cell is connected together.

9. A cell stack system (1) comprising:
the voltage measurement device (100) according to any one of claims 1 to 8; and
a cell stack (200) of n battery cells connected in series, n being an integer greater than or equal to two.

## Patentansprüche

1. Spannungsmessvorrichtung (100), die in einem Zellenstapel (200) aus n Batteriezellen ( *B*₁ *... Bₙ* ), die in Reihe geschaltet sind, eine Spannung jeder der n Batteriezellen einzeln erfasst, wobei n eine ganze Zahl größer oder gleich zwei ist, wobei die Spannungsmessvorrichtung (100) umfasst:
( *n* + 1 ) erste Widerstandselemente ( *R*₁ ...*R*_{*n*+1} ), deren erste Anschlüsse mit einer positiven Elektrode einer oberen Batteriezelle unter den n Batteriezellen, einer negativen Elektrode einer unteren Batteriezelle unter den n Batteriezellen und Verbindungspunkten zwischen den n Batteriezellen verbunden sind;
( n + 1 ) erste Kondensatoren ( C₁ ... Cₙ₊₁ ), deren erste Anschlüsse jeweils mit zweiten Anschlüssen der ( n + 1 ) ersten Widerstandselemente verbunden sind; und
eine Spannungsmesseinrichtung (30), die mit den zweiten Anschlüssen der ( n + 1 ) ersten Widerstandselemente verbunden ist,
**dadurch gekennzeichnet, dass**
zweite Anschlüsse von zwei oder mehr ersten Kondensatoren unter den ( n + 1 ) ersten Kondensatoren mit einer positiven Elektrode einer k-ten Batteriezelle unter den n Batteriezellen verbunden sind, wobei k eine ganze Zahl größer oder gleich eins und kleiner oder gleich n - 1 ist.

2. Spannungsmessvorrichtung nach Anspruch 1, ferner umfassend:
ein zweites Widerstandselement, das zwischen den zweiten Anschlüssen der zwei oder mehr ersten Kondensatoren und der positiven Elektrode der k-ten Batteriezelle verbunden ist; und
einen zweiten Kondensator, der mit den zweiten Anschlüssen der zwei oder mehr ersten Kondensatoren verbunden ist.

3. Spannungsmessvorrichtung nach Anspruch 1 oder 2, wobei
zweite Anschlüsse der ( n + 1 ) ersten Kondensatoren mit der positiven Elektrode der k-ten Batteriezelle verbunden sind.

4. Spannungsmessvorrichtung nach Anspruch 1 oder 2, ferner umfassend:
ein drittes Widerstandselement, dessen erster Anschluss mit einer positiven Elektrode einer m-ten Batteriezelle unter den n Batteriezellen verbunden ist, wobei m eine ganze Zahl größer oder gleich eins und kleiner als k ist; und
einen dritten Kondensator, dessen erster Anschluss mit einem zweiten Anschluss des dritten Widerstandselements verbunden ist, wobei
der zweite Anschluss des dritten Widerstandselements mit der Spannungsmesseinrichtung verbunden ist,
ein zweiter Anschluss des dritten Kondensators mit der positiven Elektrode der k-ten Batteriezelle verbunden ist,
unter den ( n + 1 ) ersten Kondensatoren jeder zweite Anschluss von mindestens zwei ersten Kondensatoren, die in ersten Kondensatoren enthalten sind, die mit Batteriezellen unter den n Batteriezellen bis einschließlich der m-ten Batteriezelle verbunden sind, zusammen verbunden ist, und
die zwei oder mehr ersten Kondensatoren unter den ( n + 1 ) ersten Kondensatoren erste Kondensatoren umfassen, die mit Batteriezellen unter den n Batteriezellen verbunden sind, die von einer (m + 1)-ten Batteriezelle bis zu einer n-ten Batteriezelle reichen und die k-te Batteriezelle einschließen.

5. Spannungsmessvorrichtung nach Anspruch 4, wobei
beim Messen einer Spannung der ( m + 1 )-ten Batteriezelle die Spannungsmessvorrichtung eine Spannung zwischen dem zweiten Anschluss eines a(m + 2)-ten ersten Widerstandselements unter den ( n + 1 ) ersten Widerstandselementen und dem zweiten Anschluss des dritten Widerstandselements misst.

6. Spannungsmessvorrichtung nach einem der Ansprüche 1 bis 5, wobei
die k-te Batteriezelle an einer n/2-ten Position unter den n Batteriezellen angeordnet ist.

7. Spannungsmessvorrichtung nach Anspruch 4 oder 5, wobei
unter den ( n + 1 ) ersten Kondensatoren jeder zweite Anschluss von ersten Kondensatoren, die mit Batteriezellen unter den n Batteriezellen bis einschließlich der m-ten Batteriezelle verbunden sind, zusammen verbunden ist,
die m-te Batteriezelle an einer n/3-ten Position unter den n Batteriezellen angeordnet ist, und
die k-te Batteriezelle an einer 2n/3-ten Position unter den n Batteriezellen angeordnet ist.

8. Spannungsmessvorrichtung nach Anspruch 4 oder 5, wobei
unter den ( n + 1 ) ersten Kondensatoren zweite Anschlüsse von ersten Kondensatoren, die mit Batteriezellen unter den n Batteriezellen bis einschließlich der m-ten Batteriezelle verbunden sind, in s Gruppen unterteilt sind, wobei jede Gruppe zwei oder mehr zusammen verbundene zweite Anschlüsse aufweist, wobei s eine ganze Zahl größer oder gleich zwei ist, und
die s Gruppen eine Gruppe umfassen, in der jeder zweite Anschluss der mindestens zwei ersten Kondensatoren, die in den ersten Kondensatoren enthalten sind, die mit den Batteriezellen bis einschließlich der m-ten Batteriezelle verbunden sind, zusammen verbunden ist.

9. Zellenstapelsystem (1), umfassend:
die Spannungsmessvorrichtung (100) nach einem der Ansprüche 1 bis 8; und
einen Zellenstapel (200) aus n in Reihe geschalteten Batteriezellen, wobei n eine ganze Zahl größer oder gleich zwei ist.

## Revendications

1. Dispositif de mesure de tension (100) qui détecte individuellement, dans un empilement de cellules (200) de *n* cellules de batterie ( *B*₁ ... *Bₙ* ) connectées en série, une tension de chacune des n cellules de batterie, n étant un entier supérieur ou égal à deux, le dispositif de mesure de tension (100) comprenant :
( *n* + 1 ) premiers éléments résistifs ( *R*₁ ... *R*_{*n*+1} ), dont des premières bornes sont connectées à une électrode positive d'une cellule de batterie d'extrémité supérieure parmi les n cellules de batterie, à une électrode négative d'une cellule de batterie d'extrémité inférieure parmi les *n* cellules de batterie, et à des points de connexion entre les *n* cellules de batterie ;
(n + 1) premiers condensateurs ( C₁ ... Cₙ₊₁ ), dont des premières bornes sont respectivement connectées à des secondes bornes des (n + 1) premiers éléments résistifs ; et
un mesureur de tension (30) connecté aux secondes bornes des (n + 1) premiers éléments résistifs,
**caractérisé en ce que**
des secondes bornes de deux ou plusieurs premiers condensateurs parmi les ( n + 1 ) premiers condensateurs sont connectées à une électrode positive d'une k-ième cellule de batterie parmi les *n* cellules de batterie, *k* étant un entier supérieur ou égal à un et inférieur ou égal à n - 1.

2. Dispositif de mesure de tension selon la revendication 1, comprenant en outre :
un deuxième élément résistif connecté entre les secondes bornes des deux ou plusieurs premiers condensateurs et l'électrode positive de la k-ième cellule de batterie ; et
un deuxième condensateur connecté aux secondes bornes des deux ou plusieurs premiers condensateurs.

3. Dispositif de mesure de tension selon la revendication 1 ou 2, dans lequel
des secondes bornes des ( n + 1 ) premiers condensateurs sont connectées à l'électrode positive de la k-ième cellule de batterie.

4. Dispositif de mesure de tension selon la revendication 1 ou 2, comprenant en outre :
un troisième élément résistif, dont une première borne est connectée à une électrode positive d'une m-ième cellule de batterie parmi les *n* cellules de batterie, m étant un entier supérieur ou égal à un et inférieur à k ; et
un troisième condensateur, dont une première borne est connectée à une seconde borne du troisième élément résistif, dans lequel
la seconde borne du troisième élément résistif est connectée au mesureur de tension,
une seconde borne du troisième condensateur est connectée à l'électrode positive de la k-ième cellule de batterie,
parmi les ( n + 1 ) premiers condensateurs, chaque seconde borne d'au moins deux premiers condensateurs inclus dans des premiers condensateurs connectés à, parmi les n cellules de batterie, des cellules de batterie jusqu'à et incluant la m-ième cellule de batterie est connectée ensemble, et
les deux ou plusieurs premiers condensateurs parmi les (n + 1) premiers condensateurs incluent des premiers condensateurs connectés à, parmi les n cellules de batterie, des cellules de batterie allant d'une (m + 1)-ième cellule de batterie à une n-ième cellule de batterie et incluant la k-ième cellule de batterie.

5. Dispositif de mesure de tension selon la revendication 4, dans lequel
lors de la mesure d'une tension de la ( m + 1 )-ième cellule de batterie, le dispositif de mesure de tension mesure une tension entre la seconde borne d'un a(m + 2)-ième premier élément résistif parmi les ( n + 1 ) premiers éléments résistifs et la seconde borne du troisième élément résistif.

6. Dispositif de mesure de tension selon l'une quelconque des revendications 1 à 5, dans lequel
la k-ième cellule de batterie est disposée à une n/2-ième position parmi les n cellules de batterie.

7. Dispositif de mesure de tension selon la revendication 4 ou 5, dans lequel
parmi les ( n + 1 ) premiers condensateurs, chaque seconde borne de premiers condensateurs connectés à, parmi les n cellules de batterie, des cellules de batterie jusqu'à et incluant la m-ième cellule de batterie est connectée ensemble,
la m-ième cellule de batterie est disposée à une n/3-ième position parmi les n cellules de batterie, et
la k-ième cellule de batterie est disposée à une 2n/3-ième position parmi les n cellules de batterie.

8. Dispositif de mesure de tension selon la revendication 4 ou 5, dans lequel
parmi les (n + 1) premiers condensateurs, des secondes bornes de premiers condensateurs connectés à, parmi les n cellules de batterie, des cellules de batterie jusqu'à et incluant la m-ième cellule de batterie sont divisées en s groupes, chacun avec deux ou plusieurs secondes bornes connectées ensemble, s étant un entier supérieur ou égal à deux, et
les s groupes incluent un groupe dans lequel chaque seconde borne des au moins deux premiers condensateurs inclus dans les premiers condensateurs connectés aux cellules de batterie jusqu'à et incluant la m-ième cellule de batterie est connectée ensemble.

9. Système d'empilement de cellules (1) comprenant :
le dispositif de mesure de tension (100) selon l'une quelconque des revendications 1 à 8 ; et
un empilement de cellules (200) de n cellules de batterie connectées en série, n étant un entier supérieur ou égal à deux.
